# EUROPÄISCHE PATENTSCHRIFT

(11) **EP 0 829 191 B1**
(45) Veröffentlichungstag und Bekanntmachung des Hinweises auf die Patenterteilung: **28.10.1998**
(21) Anmeldenummer: 95928431.6
(22) Anmeldetag: 16.08.1995
(51) Int. Cl.: H05K 9/00

(54) **KONTAKTFEDERLEISTE ZUM AUFSTECKEN AUF HALTELEISTEN INSBESONDERE AN DEN FRONTPLATTEN DER BAUGRUPPEN VON ABGESCHIRMTEN BAUGRUPPENTRÄGERN**
CONTACT SPRING STRIP FOR PLUGGING ONTO HOLDING STRIPS, IN PARTICULAR AT THE FRONT PANEL OF MODULES IN SHIELDED MODULE CARRIERS
CONNECTEUR A LAMES DE CONTACT A ENFICHER SUR DES REGLETTES DE RETENUE, NOTAMMENT SUR LES PANNEAUX FRONTAUX DE MODULES DANS DES SUPPORTS BLINDES DE MODULES

(30) Priorität: 01.06.1995 DE 29509102 U
(43) Veröffentlichungstag der Anmeldung: 18.03.1998
(73) Patentinhaber: SIEMENS AKTIENGESELLSCHAFT, 80333 München (DE)
(72) Erfinder: BILLENSTEIN, Ernst, D-91593 Burgbernheim (DE); KÖRBER, Werner, D-91282 Betzenstein (DE); KURRER, Siegfried, D-90449 Nürnberg (DE); SCHAFFER, Kurt-Michael, D-90542 Eckental (DE)
(86) Internationale Anmeldenummer: DE9501077
(87) Internationale Veröffentlichungsnummer: WO9639017

(56) Entgegenhaltungen:
- EP-A- 0 207 226
- EP-A- 0 456 858
- DE-C- 4 311 246
- US-A- 2 065 651

## Beschreibung

Aus der DE 41 10 800 C1 ist eine "Baugruppe zum Einschub in HF-dichte Gehäuse elektronischer Geräte" bekannt. Die Baugruppe weist eine im Profil U-förmig ausgebildete Frontplatte auf. Zur hochfrequenzmäßigen Abdichtung der Langsspalten zwischen den Frontplatten von parallel nebeneinander z.B. in einem Baugruppenträger angeordneten Baugruppen ist eine aus einer Vielzahl von kettenartig folgenden Federelementen bestehende Federleiste vorgesehen. Diese ist auf dem die eine Seite des U-förmigen Profils der Frontplatte einer Baugruppe bildenden Längssteg aufgesteckt und kontaktiert diese Frontplatte elektromagnetisch und hochfrequenzdicht mit der gegenüberliegenden, die andere Seite des U-förmigen Profils der Frontplatte einer benachbarten Baugruppe bildenden Längsleiste.

Ein Federelement der Federleiste besteht aus zwei gleich ausgebildeten Kontaktfedern mit je einem Federblatt sowie einer dazwischen angeordneten Federklemme mit einem Klemmblatt. Die Kontaktfedern und die Federklemme haben ein gemeinsames, ebenes Rückseitenblatt. Federklemme und Rückseitenblatt sind im Querschnitt U-förmig ausgebildet und auf den Längssteg der Frontplatte klemmend so aufschiebbar, daß das Rückseitenblatt an der Innenseite des Längssteges aufliegt. Kontaktfedern und Rückseitenblatt haben V-förmigen Querschnitt, so daß deren Federblätter von der Außenseite des Längssteges abgespreizt sind.

Ein Problem bei dieser Anordnung wird darin gesehen, daß für eine ordnungsgemäße und ausreichende Klemmwirkung die zusammenwirkenden Elemente Federklemme und Rückseitenblatt und der Längssteg, auf den diese Elemente aufgeschoben werden, eine ausreichende Höhe aufweisen müssen. Diese hat seine Ursache im wesentlichen darin, daß die Haltewirkung überwiegend durch Ausnutzung von Reibungskräften erzielt wird. Ein weiteres, damit zusammenhängendes Problem wird darin gesehen, daß das Element Federklemme auf der Vorderseite des Federelementes ferner eine ausreichende Breite aufweisen muß, um die notwendige Klemmwirkung zu erzielen. Hierdurch bedingt ist der Abstand zwischen den beidseitig der Federklemme angeordneten Kontaktfedern relativ groß. Zur Erzielung einer durchgehenden Kontaktierung und somit ausreichenden Schirmwirkung ist es notwendig, daß die Federblätter durch eine Verbindungsbrücke im unteren Bereich miteinander verbunden sind. Da diese Verbindungsbrücke aber wegen der dazwischen liegenden, hohen Federklemme nur schmal und stegartig ausführbar ist, besteht leicht die Gefahr einer mechanischen Beschädigung derselben.

Der Erfindung liegt somit die Aufgabe zugrunde, eine Kontaktfederleiste anzugeben, womit insbesondere die oben aufgeführten Nachteile vermieden werden.

Die Aufgabe wird gelöst mit der im Anspruch 1 angegebenen Kontaktfederleiste. Vorteilhafte weitere Ausführungsformen der Erfindung sind in den Unteransprüchen angegeben.

Die Erfindung und die damit verbundenen Vorteile werden mit den in den nachfolgend kurz angeführten Figuren dargestellten Beispielen nachfolgend näher erläutert. Dabei zeigt
- Fig.1.: eine Schnittdarstellung durch eine erste Ausführungsform einer auf einer Halteleiste aufgerasteten erfindungsgemäßen Kontaktfederleiste,
- Fig.2.: eine perspektivische Seitenansicht auf die Vorderseite von zwei kettenartig zusammenhängenden Kontaktfedern gemäß einer zweiten Ausführungsform, welche einen Ausschnitt aus einer Kontaktfederleiste darstellen,
- Fig.3.: eine perspektivische Seitenansicht auf die Rückseite der zwei kettenartig zusammenhängenden Kontaktfedern gemäß Fig.2,
- Fig.4.: eine perspektivische Seitenansicht auf die Vorderseite von zwei kettenartig zusammenhängenden Kontaktfedern, welche im wesentlichen der in Figur 2 dargestellten Ausführungsform entsprechen, aber über biberschwanzartig verbreiterte Federblätter verfügen, und
- Fig.5.: eine im wesentlichen der Ausführung gemäß der Figuren 2 bis 4 entsprechende Schnittdarstellung einer auf einen Seitensteg der Frontplatte einer Flachbaugruppe aufgerasteten Kontaktfederleiste gemäß der Erfindung.

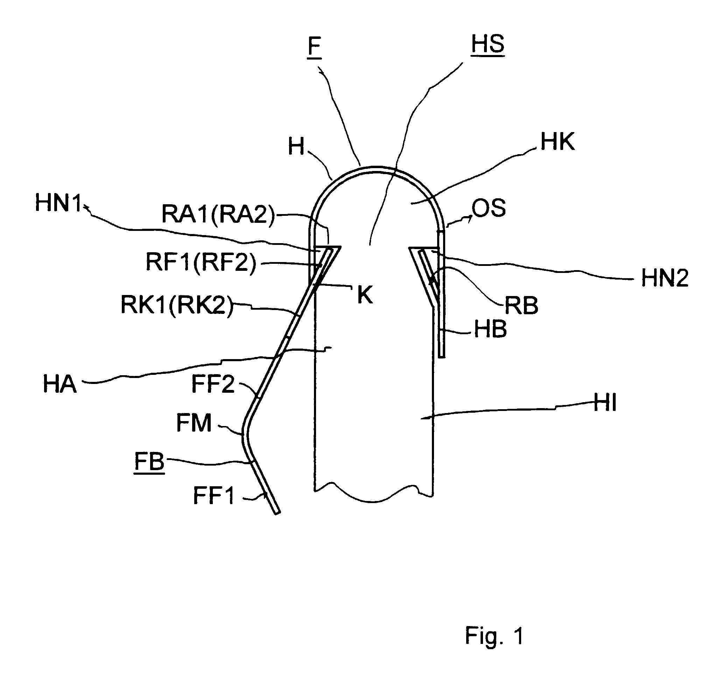

In der Schnittdarstellung gemäß Figur 1 ist der obere Bereich einer Halteleiste HS dargestellt, welche als Träger für eine aufgerastete Kontaktfederleiste gemäß der Erfindung dient. Die Halteleiste weist eine Vorderseite HA und eine Rückseite HI auf. Auf der als Kontaktbereich dienenden Vorderseite HA kommen die Federblätter FB der Kontaktfedern F der Kontaktfederleiste zu liegen, während die Rückseite HI quasi als Widerlager zur Halterung der Kontaktfeder dient.

Ein Hutbereich H der Kontaktfeder F umfaßt den Kopfbereich HK der Halteleiste HS und liegt dort möglichst formschlüssig auf. Im dargestellten Beispiel ist der Kopfbereich HK abgerundet, so daß der formmäßig angepaßte Hutbereich bei dieser Ausführung im Querschnitt umgekehrt u- bzw. rinnenförmig ist. Bei einer anderen, nicht dargestellten Ausführung ist es auch möglich, daß der Kopfbereich HK rechteckfömig und kantig gestaltet ist, so daß dann der Hutbereich H der Kontaktfederleiste umgekehrt schachtförmig ist.

Erfindungsgemäß ist ein Federblatt FB, worüber bei Berührung mit gegenüberliegenden, zum Zwecke der besseren Übersicht in Figur 1 nicht dargestellten Bauteilen eine elektrisch leitende Kontaktierung bewirkt wird, ausgehend von einer Knickkante K vom Hutbereich H nach außen abgespreizt. Das Federblatt FB der Kontaktfeder weist bevorzugt einen dachförmigen Querschnitt auf. Es ergibt sich in diesem Fall eine Federflanke FF2, welche von der Knickkante K bis zu einer am weitesten von der Vorderseite HA der Halteleiste HS abstehenden Federmitte FM verläuft. Ferner ergibt sich im Anschluß daran eine weitere Federflanke FF1, welche von der Federmitte FM aus wieder auf die Vorderseite HA gerichtet verläuft.

Die Kontaktfeder gemäß der Erfindung verfügt ferner über zwei Rastkrallen RK1 und RK2, welche vom Hutbereich H ausgehend auf der Vorderseite HA der Halteleiste HS an der Knickkante K in annähernd der gleichen Weise wie das Federblatt FB nach außen abgespreizt und beidseitig neben dem Federblatt FB liegend freigeschnitten sind. In der seitlichen Querschnittsdarstellung von Figur 1 ist die vordere Rastkralle RK1 zu sehen, während die andere Rastkralle RK2 in der Zeichenebene liegt. Aus diesem Grund sind die zur Rastkralle RK2 gehörenden Bezugszeichen in Figur 1 in Klammern gesetzt. Erfindungsgemäß weist jede Rastkralle RK1,RK2 eine nach oben in Richtung auf den Kopfbereich HK und die Vorderseite HA der Halteleiste HS abgespreizte Haltefahne RF1,RF2 auf, die ganz oben in einer Rastkante RA1,RA2 endet. Die Haltefahnen RF1,RF2 können gemäß der Darstellung in Figur 1 im aufgesteckten Zustand der Kontaktfeder (F) vorteilhaft in eine erste Rastnut HN1 eingreifen, welche auf der Vorderseite HA annähernd unterhalb des Kopfbereiches HK in die Halteleiste HS eingebracht ist, und werden darin über die Rastkanten RA1,RA2 abgestützt.

Gemäß einer anderen, nicht dargestellten Ausführungsform ist es auch möglich, auf eine Rastnut in der Halteleiste HS zu verzichten, so daß die Rastkanten RA1,RA2 klemmend und u.U. bis zu einem gewissen Grad auch schneidend unmittelbar auf die Fläche der Vorderseite HA der Halteleiste HS eingreifen.

Schließlich weist die erfindungsgemäße Kontaktfeder F noch ein Halteblatt HB auf, welches vom Hutbereich H ausgehend auf die Rückseite HI der Halteleiste HS reicht und aus dem mindestens eine Haltefahne RB ausgeschnitten und in Richtung auf die Rückseite HI der Halteleiste HS abgespreizt ist. Diese greift bevorzugt in eine zweite Rastnut HN2 ein, welche auf der Rückseite HI vorteilhaft ebenfalls annähernd unterhalb des Kopfbereiches HK in die Halteleiste HS eingebracht ist.

Auch hier ist es gemäß einer anderen, nicht dargestellten Ausführungsform möglich, auf eine Rastnut in der Halteleiste HS zu verzichten, so daß die Haltefahne klemmend und u.U. bis zu einem gewissen Grad auch schneidend unmittelbar auf die Fläche der Rückseite HI der Halteleiste HS eingreift. In diesem Fall wird die Kontaktfeder also auf eine Halteleiste aufgeschoben, welche über ebene, nicht von Nuten u. dgl. durchbrochene Vorder- und Rückseiten verfügt.

Die erfindungsgemäße Ausführung weist den besonderen Vorteil auf, daß die Verrastung der Kontaktfeder F mit der Halteleiste HS im wesentlichen annähernd unterhalb von deren Kopfbereiches HK erfolgt, so daß die Halteleiste HS selbst an sich keine große Höhe aufweisen muß. Das abgespreizte Federblatt FB der Kontaktfeder ist somit nahezu vollständig entkoppelt von haltenden Rastkrallen RK1 und RK2.

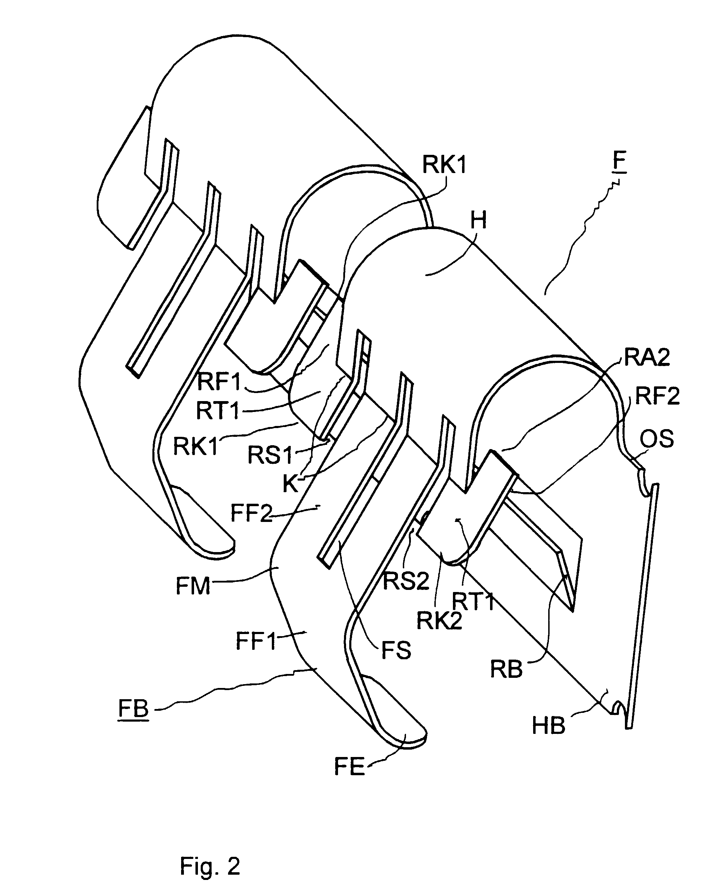

Der Vorteil dieser Ausgestaltung ist in Figur 2 besonders deutlich zu erkennen, welche eine perspektivische Draufsicht auf die Vorderseite von zwei, kettenartig zusammenhängenden Kontaktfedern F zeigt. Eine sehr große Vielzahl von derartigen Kontaktfedern kann zu einer Kontaktfederleiste verbunden sein.

Die Kontaktfeder FM ist beidseitig über je einen Freischnitt bzw. Schlitz RS1 und RS2 von den benachbarten Rastkrallen RK1 und RK2 freigeschnitten. Jede der beiden Rastkrallen verfügt über je eine Tragfläche RT1,RT2, die in fertigungstechnisch günstiger Weise wie das dazwischen liegende Federblatt FM an der Knickkante K vom Hutbereich H nach vorne abgespreizt sind. Hierdurch bedingt sind die oberhalb der Kickkante K nach hinten abgehenden fahnenförmigen Verlängerungen RF1,RF2, desweiteren Haltefahnen genannt, umgekehrt in Richtung auf die Vorderseite der Halteleiste abgespreizt und können über deren Rastkanten RA1,RA2 an den oberen Enden der Rastfahnen RF1,RF2 optimal in eine entsprechende Rastnut der Halteleiste einrasten. Aufgrund der erfindungsgemäßen Gestaltung sind das Federblatt FB und die beidseitigen Rastkrallen RK1,RK2 somit funktionell optimal voneinander entkoppelt. Vorteilhaft können hierzu die Freischnitte RS1,RS2 nach oben über die Knickkante K hinaus bis in den Hutbereich H hinein verlängert werden.

Bei der in Figur 2 dargestellten Ausführung ist das auf der Rückseite der Halteleiste aufliegende Halteblatt HB verlängert ausgeführt. Die freigeschnittene, mindestens eine Haltefahne RB kommt dann mehr im unteren Bereich des Halteblattes HB zu liegen. Hierdurch kann die Halterung der Kontaktfeder F an der Halteleiste insbesondere bei Auftreten von besonders starken, insbesondere auf die Federmitte FM einwirkenden Schub-, Verformungs- und Reibkräften verbessert werden.

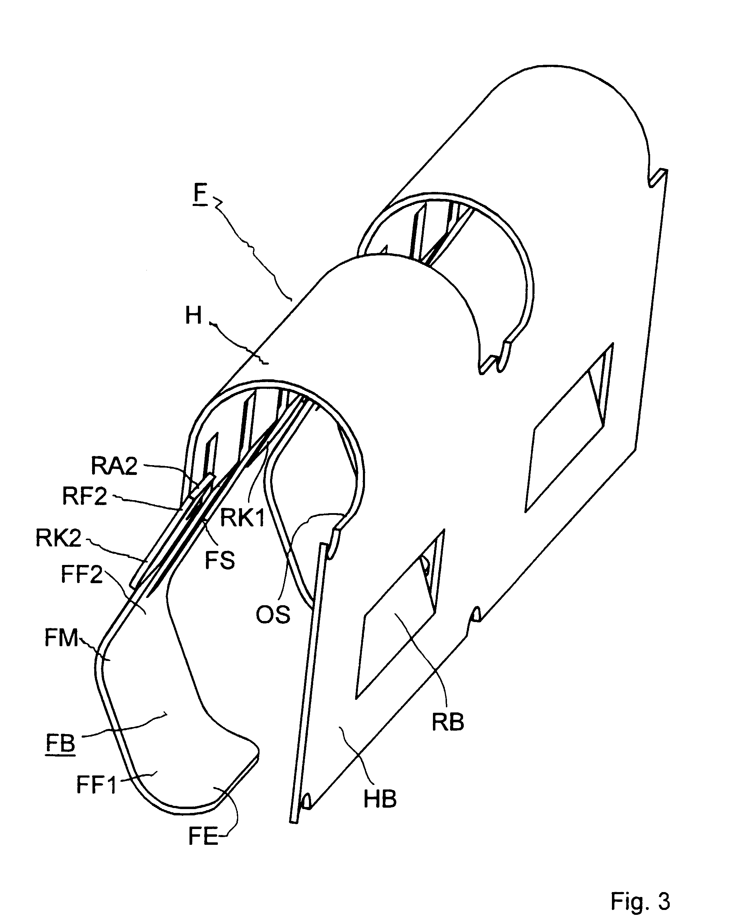

Gemäß einer weiteren, in den Figuren 2 und 3 bereits dargestellten Ausführung weist das Federblatt FB selbst einen Längsschlitz FS auf. Hierdurch wird die Feder "weicher" und kann sich somit leichter elastisch verformen auf Grund von schräg tangential insbesondere auf die zweite Federflanke FF2 auftreffenden Druck- und Reibkräfte beim Kontaktiervorgang mit gegenüber liegenden Kontaktflächen, welche bevorzugt Bestandteil der Seite einer benachbarten Frontplatte einer weiteren Baugruppe sind.

Vorteilhaft ist die untere, den eingreifenden Kräften abgewandte erste Federflanke FF1, welche von der Federmitte FM bis zum Federende FE verläuft, massiv gefüllt. Hierdurch hat diese erste Federflanke eine ausreichende innere Steifigkeit gegen Verwindungen. Vorteilhaft verläuft der Längsschlitz FS lediglich entlang der zweiten Federflanke FF2, d.h. zumindest etwa von der Federmitte FM bis zur Knicklinie. Es wird somit nur diejenige Federflanke "weicher", welche bei einem Kontaktiervorgang besonders starken Verformungen ausgesetzt ist. Reicht der Längsschlitz FS gemäß der Darstellung in Figur 2 bevorzugt nach oben über die Knickkante K hinaus bis in den Hutbereich H, so wird die zerstörungsfreie Verformbarkeit der Kontaktfeder F weiter gefördert. Generell kann durch entsprechende Wahl der Breite des Längsschlitzes FS und der Breiten der beiden rechts bis zum Freischlitz RS1 und links bis zum Freischlitz RS2 reichenden Stege des Federblattes FB dessen Federcharakteristik eingestellt werden.

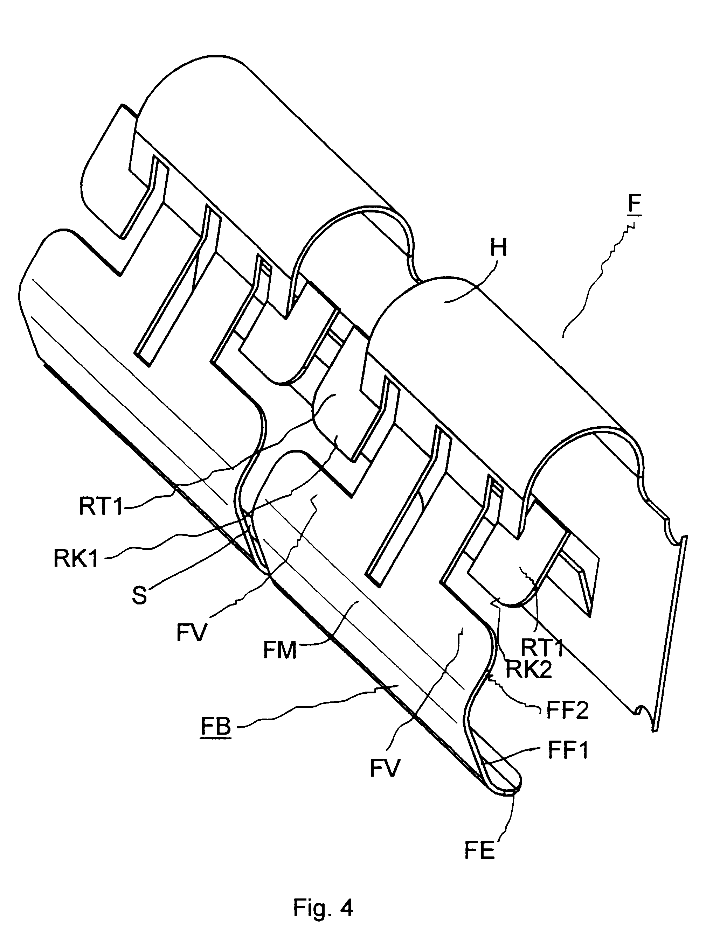

Figur 4 zeigt eine weitere perspektivische Seitenansicht auf die Vorderseite von beispielhaft zwei kettenartig zusammenhängenden Kontaktfedern. Diese entsprechen zwar im wesentlichen der in Figur 2 dargestellten Ausführungsform, verfügen aber über biberschwanzartig verbreiterte Federblätter. So ist die Fläche des Federblattes FB sowohl auf der linken als auch auf der rechten Seite durch Verbreiterungen FV so vergrößert, daß die Federblätter benachbarter Kontaktfedern nur noch über einen schmalen Spalt S voneinander getrennt sind. Wie in Figur 4 bereits dargestellt, entsprechen die Breiten der Verbreiterungen FV besonders vorteilhaft annähernd den Breiten der in Richtung auf den Hutbereich H darüber liegend angeordneten Rastkrallen RK1,RK2. Es sind somit im Vergleich zur Ausführung von Figur 2 im Beispiel der Figur 4 beidseitig der Federmitte FM eines Federblattes FB jeweils die Bereiche der ersten und zweiten Federflanke FF1,FF2 in Richtung der Erstreckung einer aus einer Vielzahl von kettenartig zusammenhängenden Kontaktfedern F bestehenden Kontaktfederleiste verlängert. Die Federmitten FM von derart zu einer Kontaktfederleiste zusammengefaßten Kontaktfedern bilden somit einen nahezu durchgehenden Auflagebereich für gegenüberliegende Bauteile inbesondere von benachbarten Flachbaugruppen und sind somit nur noch durch den schmalen Spalt S voneinander getrennt.

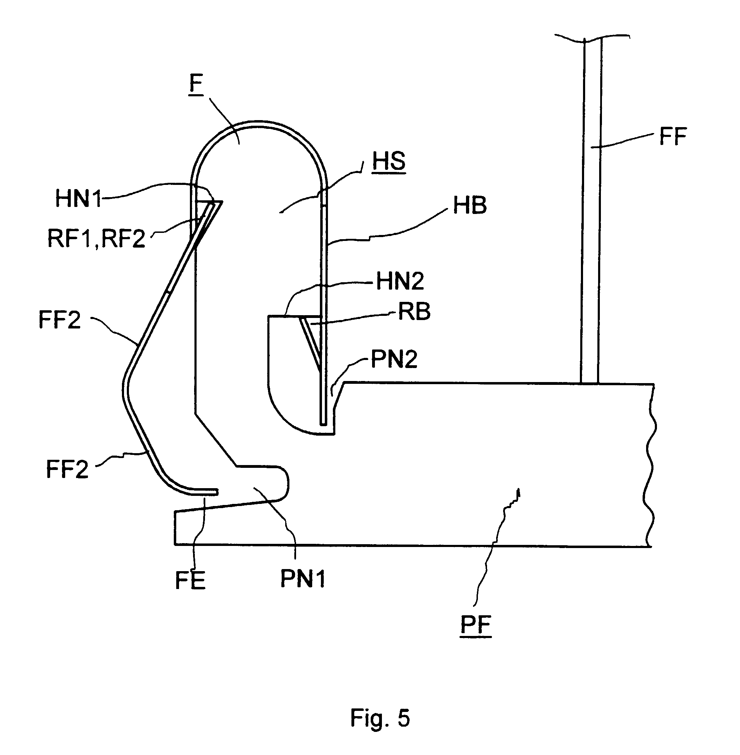

Bevorzugt bildet das Federende FE eine stark nach innen gerichtete Abknickung des Federblattes FB. Dies ist insbesondere dann von Vorteil, wenn die erfindungsgemäße Kontaktfeder bzw. eine daraus gebildete Kontaktfederleiste auf eine Halteleiste aufgerastet wird, welche ein Seitenteil der Frontplatte einer Flachbaugruppe darstellt. Eine solche Verwendung ist im Beispiel der Figur 5 dargestellt. Bei Flachbaugruppen ist damit zu rechnen, daß diese häufiger aus einem Baugruppenträger entnommen und wieder eingesteckt werden. Es können somit wiederholt starke Verformungskräfte in schräg tangentialer Richtung von unten auch auf die zweite Federflanke FF1 einwirken. Zur Vermeidung von irreversiblen Verformungen und gegebenenfalls sogar Verklemmungen ist es vorteilhaft, wenn das untere Federende FE stark nach innen abgeknickt ist.

Figur 5 zeigt das linke Ende der Frontplatte PF einer Flachbaugruppe FF. Parallel zur Flachbaugruppe erstreckt sich eine Halteleiste HS, auf die eine gemäß der Erfindung gestaltete Kontaktfeder F aufgerastet ist. Es ist deutlich zu erkennen, daß auf Grund der Verrastung der Kontaktfeder zumindest mit der Vorderseite der Halteleiste HS in deren Kopfbereich sowohl die tragende Halteleiste als auch die Kontaktfeder nur eine geringe Bauhöhe aufzuweisen brauchen. Vorteilhaft verfügt die Frontplatte PF in Figur 5 seitlich über eine erste Eingriffsnut PN1, in die das Federende FE der Kontaktfeder F eintauchen kann. Vorteilhaft ist eine zweite Eingriffsnut PN2 im Achselbereich zwischen der Innenseite der Frontplatte PF und der Rückseite der Halteleiste HS vorhanden. Diese kann zum einen die Funktion der Rastnut HN2 zur Aufnahme der Haltefahne RB übernehmen. Zum anderen kann das untere Ende eines nach unten verlängerten Halteblattes HB darin eine seitliche Abstützung finden.

## Patentansprüche

1. Kontaktfederleiste aus einer Vielzahl von kettenartig zusammenhängenden Kontaktfedern (F), zum Aufstecken auf eine Halteleiste (HS) insbesondere an der Frontplatte (PF) einer Flachbaugruppe, wobei jede Kontaktfeder (F) enthält
a) einen Hutbereich (H), zur Umfassung des Kopfbereichs (HK) der Halteleiste (HS),
b) ein Federblatt (FB), welches an einer Knickkante (K) vom Hutbereich (H) ausgehend auf der Vorderseite (HA) der Halteleiste (HS) nach außen abgespreizt ist,
c) zwei Rastkrallen (RK1,RK2), welche
c1) vom Hutbereich (H) ausgehend an der Knickkante (K) nach außen abgespreizt und beidseitig neben dem Federblatt (FB) liegend freigeschnitten sind, und
c2) die jeweils eine in Richtung auf den Kopfbereich (HK) und die Vorderseite (HA) der Halteleiste (HS) abgespreizte Haltefahne (RF1,RF2) mit einer Rastkante (RA1,RA2) aufweisen, und
d) ein Halteblatt (HB), welches vom Hutbereich (H) ausgehend auf die Rückseite (H1) der Halteleiste (HS) reicht und aus dem mindestens eine Haltefahne (RB) ausgeschnitten und in Richtung auf die Rückseite (HI) der Halteleiste (HS) abgespreizt ist.

2. Vorrichtung nach Anspruch 1, wobei die Rastkrallen (RK1,RK2) über die Knickkante (K) hinaus bis in den Hutbereich (H) freigeschnitten sind.

3. Vorrichtung nach Anspruch 1 oder 2, wobei das Federblatt (FB) einen Längsschlitz (FS) aufweist.

4. Vorrichtung nach Anspruch 1 oder 2, wobei das Federblatt (FB) bei annähernd dachförmigen Querschnitt (FF1,FM,FF2) eine erste, von der Federmitte (FM) bis zum Federende (FB) verlaufende Federflanke (FF1) und eine zweite, von der Federmitte (FM) bis zur Knickkante (K) verlaufende Federflanke (FF2) aufweist.

5. Vorrichtung nach Anspruch 4, wobei das Federblatt (FB) in der auf den Hutbereich (H) zulaufenden Federflanke (FF2) einen Längsschlitz (FS) aufweist.

6. Vorrichtung nach einem der Ansprüche 3 oder 5, wobei der Längsschlitz (FS) über die Knickkante (K) hinaus bis in den Hutbereich (H) reicht.

7. Vorrichtung nach einem der vorangegangenen Ansprüche, wobei die aus dem Halteblatt (HB) geschnittene und abgespreizte Haltefahne (RB) in eine Rastnut (HN2) auf der Rückseite (HI) der Halteleiste (HK) eingreift.

8. Vorrichtung nach einem der vorangegangenen Ansprüche, wobei die Rastkanten (RA1,RA2) der abgespreizten Haltefahnen (RF1,RF2) der Rastkrallen (RK1,RK2) in eine Rastnut (HN1) auf der Vorderseite (HA) der halteleiste (HK) eingreifen.

9. Vorrichtung nach einem der vorangegangenen Ansprüche, wobei das Federblatt (FB) beidseitig biberschwanzartige Verbreiterungen (FV) aufweist.

10. Vorrichtung nach Anspruch 9, wobei die Breiten der biberschwanzartigen Verbreiterungen (FV) des Federblatts (FB) annähernd den Breiten der in Richtung auf den Hutbereich (H) darüber liegend angeordneten Rastkrallen (RK1,RK2) entsprechen.

## Claims

1. Contact spring strip composed of a multiplicity of contact springs (F) arranged together like a chain, for plugging onto a holding strip (HS), in particular at the front panel (PF) of a printed circuit board, each contact spring (F) containing
a) a hat region (H) for covering the head region (HK) of the holding strip (HS),
b) a spring leaf (FB) which is spread away outwards at a bend edge (K) of the hat region (H) on the front side (HA) of the holding strip (HS),
c) two latching claws (RK1, RK2), which
c1) are bent away outwards, starting from the hat region (H), at the bend edge (K) and are cut free situated on both sides next to the spring leaf (FB), and
c2) which in each case have a holding lug (RF1, RF2), which is spread away in the direction of the head region (HK) and of the front side (HA) of the holding strip (HS) and has a latching edge (RA1, RA2), and
d) a holding blade (HB) which, starting from the hat region (H), reaches up to the rear side (HI) of the holding strip (HS), and from which at least one holding lug (RB) is cut out and spread away in the direction of the rear side (HI) of the holding strip (HS).

2. Device according to Claim 1, the lacchinp claws (RK1, RK2) being cut free beyond the bend edge (K) as far as into the hat region (H).

3. Device according to Claim 1 or 2, the spring leaf (FB) having a longitudinal slot (FS).

4. Device according to Claim 1 or 2, the spring leaf (FB) having, in the case of an approximately roof-shaped cross-section (FF1, FM, FF2), a first spring flank (FF1) running from the middle of the spring (FM) up to the end of the spring (FB), and a second spring flank (FF2), running from the middle of the spring (FM) as far as the bend edge (K).

5. Device according to Claim 4, the spring leaf (FB) having a longitudinal slot (FS) in the spring flank (FF2) running up to the at region (H).

6. Device according to one of Claims 3 or 5, the longitudinal slot (FS) reaching beyond the bend edge (K) as far as into the hat region (H).

7. Device according to one of the preceding claims, the holding lug (RB) cut and spread away from the holding blade (HB) engaging in a latching groove (HN2) on the rear side (HI) of the holding strip (HK).

8. Device according to one of the preceding claims, the latching edges (RA1, RA2) of the spread-away holding lugs (RF1, RF2) of the latching claws (RK1, RK2) engaging in a latching groove (HN1) on the front side (HA) of the holding strip (HK).

9. Device according to one of the preceding claims, the spring leaf (FB) having extensions (FV) resembling beaver tails on both sides.

10. Device according to Claim 9, the widths of the extensions (FB) of the spring leaf (FB) which resemble beaver tails corresponding approximately to the widths of the latching claws (RK1, RK2) arranged situated thereabove in the direction of the hat region (H).

## Revendications

1. Barrette à lames de contact élastiques constituée d'un grand nombre de lames de contact (F) élastiques raccordées les unes aux autres de façon continue à la manière d'une chaîne, la barrette étant destinée à être enfichée sur une réglette de retenue (HS), notamment sur la plaque frontale (PF) d'un module plat, chaque lame de contact (F) élastique comprenant
a) une zone de coiffe (H) destinée à enserrer la zone de tête (HK) de la réglette de retenue (HS),
b) une patte de lame élastique (FB), qui est écartée vers l'extérieur sur une arête de pliage (K) à partir de la zone de coiffe (H) sur le côté avant (HA) de la réglette de retenue (HS)
c) deux griffes d'encliquetage (RK1, RK2), qui
c1) à partir de la zone de coiffe (H) sont écartées vers l'extérieur sur l'arête de pliage (K) et sont situées de part et d'autre à côté de la patte de lame élastique (FB) en étant dégagées de cette dernière par une découpe, et qui
c2) présentent chacune un talon de retenue (RF1, RF2) écarté en direction de la zone de tête (HK) et du côté avant (HA) de la réglette de retenue (HS), et comportant un bord d'encliquetage (RA1, RA2), et
d) une patte de retenue (HB), qui en étant issue de la zone de coiffe (H) s'étend jusque sur le côté arrière (HI) de la réglette de retenue (HS), et de laquelle est découpé au moins un talon de retenue (RB) écarté en direction du côté arrière (HI) de la réglette de retenue (HS).

2. Dispositif selon la revendication 1, les griffes d'encliquetage (RK1, RK2) étant dégagées par une découpe au-delà de l'arête de pliage (K) jusque dans la zone de coiffe (H).

3. Dispositif selon la revendication 1 ou 2, la patte de lame élastique (FB) présentant une fente longitudinale (FS).

4. Dispositif selon la revendication 1 ou 2, la patte de lame élastique (FB) de section transversale (FF1, FM, FF2) approximativement en forme de toit, présentant un premier flanc (FF1) de lame élastique qui s'étend du centre (FM) de la lame élastique jusqu'à l'extrémité (FE) de la lame élastique, et un second flanc (FF2) de lame élastique qui s'étend du centre (FM) de la lame élastique jusqu'à l'arête de pliage (K).

5. Dispositif selon la revendication 4, la lame élastique (FB) présentant une fente longitudinale (FS) dans le flanc (FF2) de la lame élastique, qui s'étend vers la zone de coiffe (H).

6. Dispositif selon l'une des revendications 3 ou 5, la fente longitudinale (FS) s'étendant au-delà de l^{,}arête de pliage (K) jusque dans la zone de coiffe (H).

7. Dispositif selon l'une des revendications précédentes, le talon de retenue (RB) découpé de la patte de retenue (HB) et écarté par rapport à celle-ci, s'engageant dans une rainure d'encliquetage (HN2) sur le côté arrière (HI) de la réglette de retenue (HK).

8. Dispositif selon l'une des revendications précédentes, les bords d'encliquetage (RA1, RA2), des talons de retenue (RF1, RF2) écartés des griffes d'encliquetage (RK1, RK2), s'engageant tans une rainure d'encliquetage (HN1) sur le côté avant (HA) de la réglette de retenue (HS).

9. Dispositif selon l'une des revendications précédentes, la patte de lame élastique (FB) présentant de chaque côté des élargissements (FV) en forme d'écaille.

10. Dispositif selon la revendication 9, les largeurs des élargissements (FV) en forme d'écaille de la patte de lame élastique (FB) correspondant sensiblement aux largeurs des griffes d'encliquetage (RK1, RK2) disposées au-dessus des élargissements, en direction de la zone de coiffe (H).
